# EUROPEAN PATENT APPLICATION

(11) **EP 4 284 136 A1**
(43) Date of publication of application: **29.11.2023**
(21) Application number: 22759901.6
(22) Date of filing: 17.01.2022
(51) Int. Cl.: H05K 9/00, H05K 1/11, H05K 3/34

(54) **PRINTED CIRCUIT BOARD ASSEMBLY**

(30) Priority: 24.02.2021 KR 20210024901
(71) Applicant: Samsung Electronics Co., Ltd., Suwon-si, Gyeonggi-do 16677 (KR)
(72) Inventor: SUNG, Euisuck, Suwon-si Gyeonggi-do 16677 (KR); NAM, Meekyeong, Suwon-si Gyeonggi-do 16677 (KR); KO, Hyeonmin, Suwon-si Gyeonggi-do 16677 (KR); KIM, Taewoo, Suwon-si Gyeonggi-do 16677 (KR); PARK, Jonghan, Suwon-si Gyeonggi-do 16677 (KR); LEE, Yongseok, Suwon-si Gyeonggi-do 16677 (KR); LIM, Jaehan, Suwon-si Gyeonggi-do 16677 (KR); JEONG, Ilyoung, Suwon-si Gyeonggi-do 16677 (KR)
(74) Representative: Nederlandsch Octrooibureau
(86) International application number: PCT/KR2022/000715
(87) International publication number: WO 2022/181982

(57) **Abstract**

A printed circuit board assembly 200 includes a printed circuit board 210, a pair of shield cans 220a or 220b adjacent to each other on the printed circuit board 210 such that a pair of adjacent corners 2211a or 2211b adjacent to each other is parallel to each other, and a pair of adjacent bonding pads 231a or 231b corresponding to the pair of adjacent corners 2211a or 2211b on the printed circuit board 210 and configured to mediate bonding between the pair of adjacent corners 2211a or 2211b and the printed circuit board 210, in which each of the pair of adjacent bonding pads 231a or 231b includes a reference structure 2311a or 2311b and a facing structure 2312a or 2312b, in which the reference structure 2311a or 2311b is formed in a longitudinal direction of the pair of adjacent corners 2211a or 2211b and the facing structure extends in a facing direction in a portion on a facing side 2311'a or 2311'b of the reference structure 2311a or 2311b, and the pair of adjacent bonding pads 231a or 231b is arranged such that edges of the facing structure 2312a or 2312b contact each other, or the facing structure 3312a or 3312b of one of the pair of adjacent bonding pads 331a or 331b and the facing structure 3312a or 3312b of the other of the pair of adjacent bonding pads 331a or 331b alternate with each other in the longitudinal direction of the reference structure 3311a or 3311b.

## Description

### Technical Field

The disclosure relates to a printed circuit board assembly.

### Background Art

Recently, demands for portable devices have been rapidly increasing in the electronic product market, and there are constant requests for the miniaturization and lightening of such portable devices. The shielding of high-frequency noise has also become important with the advancement of these portable devices. To this end, a structure for covering electronic elements that are mounted on a printed circuit board with a shield can is used.

### Disclosure of the Invention

### Technical Goals

The need to decrease a distance between components has increased to miniaturize electronic products, and accordingly, the decreasing of a distance between shield cans adjacent to one another is also required. In addition, to mount a shield can on a printed circuit board (PCB), a bonding pad is used to mediate the bonding of the shield can and the PCB. To decrease the distance between the shield cans adjacent to one another, a distance between bonding pads at adjacent corners may need to decrease.

According to an embodiment, the density of components that are mounted on a PCB assembly may increase, and the size of the PCB assembly may decrease.

According to an embodiment, the distance between the adjacent shield cans may decrease.

According to an embodiment, at least one of a pair of adjacent shield cans may be prevented from leaning in a direction facing each other.

However, the goals to be achieved are not limited to those described above and may be expanded in various manners within the scope without departing from the spirit and field of the disclosure.

### Technical Solutions

According to an embodiment, a PCB assembly 200 includes a PCB 210; a pair of shield cans 220a or 220b adjacent to each other on the PCB 210 such that a pair of adjacent corners 2211a or 2211b adjacent to each other is parallel to each other; and a pair of adjacent bonding pads 231a or 231b corresponding to the pair of adjacent corners 2211a or 2211b on the PCB 210 and configured to mediate bonding between the pair of adjacent corners 2211a or 2211b and the PCB 210, in which each of the pair of adjacent bonding pads 231a or 231b includes a reference structure 2311a or 2311b and a facing structure 2312a or 2312b, in which the reference structure 2311a or 2311b is formed in a longitudinal direction of the pair of adjacent corners 2211a or 2211b and the facing structure extends in a facing direction in a portion on a facing side 2311'a or 2311'b of the reference structure 2311a or 2311b, and the pair of adjacent bonding pads 231a or 231b is arranged such that edges of the facing structure 2312a or 2312b contact each other, or the facing structure 3312a or 3312b of one of the pair of adjacent bonding pads 331a or 331b and the facing structure 3312a or 3312b of the other of the pair of adjacent bonding pads 331a or 331b alternate with each other in the longitudinal direction of the reference structure 3311a or 3311b.

### Effects

According to an embodiment, with at least some of a bonding pad functioning as a reference line for guiding a position where a shield can is mounted, at least one of a pair of shield cans adjacent to each other may be prevented from leaning in a direction facing each other.

According to an embodiment, for a pair of shield cans adjacent to each other, a distance between the adjacent shield cans may decrease by decreasing a distance between adjacent bonding pads.

According to an embodiment, by decreasing a distance between adjacent shield cans, the density of components mounted on a PCB may increase, and the PCB may be miniaturized.

The effects to be achieved are not limited to those described above, and other effects not mentioned above will be clearly understood by one of ordinary skill in the art from the following description.

### Brief Description of Drawings

FIG. 1 is a block diagram illustrating an electronic device in a network environment according to an embodiment.
FIG. 2A is an exploded perspective view illustrating a printed circuit board according to an embodiment.
FIG. 2B is a plan view of a printed circuit board including a bonding pad according to an embodiment.
FIG. 2C is a plan view of a printed circuit board assembly according to an embodiment.
FIG. 2D is a plan view of the inside of A of FIG. 2C.
FIG. 2E is a front view taken along a line I-I of FIG. 2D and illustrating a state before a bonding member is applied.
FIG. 2F is a front view taken along a line II-II of FIG. 2D and illustrating a state before a bonding member is applied.
FIG. 2G is a front view taken along a line I-I of FIG. 2D and illustrating a state after a bonding member is applied.
FIG. 2H is a front view taken along a line II-II of FIG. 2D and illustrating a state after a bonding member is applied.
FIG. 3 is a plan view of a pair of adjacent bonding pads applied to a pair of shield cans adjacent to each other, according to an embodiment.
FIG. 4 is a plan view of a pair of adjacent bonding pads applied to a pair of shield cans adjacent to each other, according to an embodiment.
FIG. 5 is a plan view of the printed circuit board assembly according to an embodiment.

### Best Mode for Carrying Out the Invention

Hereinafter, embodiments will be described in detail with reference to the accompanying drawings. When describing the embodiments with reference to the accompanying drawings, like reference numerals refer to like elements and a repeated description related thereto will be omitted.

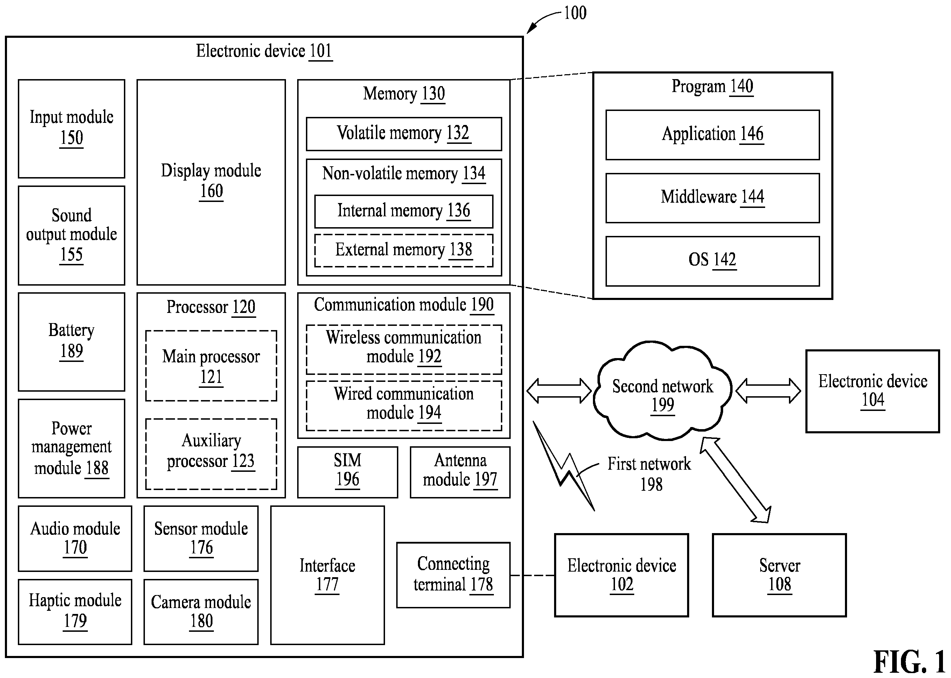

FIG. 1 is a block diagram illustrating an electronic device in a network environment according to an embodiment.

Referring to FIG. 1, an electronic device 101 in a network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added in the electronic device 101. In some embodiments, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 connected to the processor 120, and may perform various data processing or computation. According to an embodiment, as at least a part of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently from, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented as separate from, or as part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an ISP or a CP) may be implemented as part of another component (e.g., the camera module 180 or the communication module 190) functionally related to the auxiliary processor 123. According to an embodiment, the auxiliary processor 123 (e.g., an NPU) may include a hardware structure specified for artificial intelligence model processing. An artificial intelligence model may be generated through machine learning. Such learning may be performed, for example, by the electronic device 101 in which an artificial intelligence model is executed, or via a separate server (e.g., the server 108). Learning algorithms may include, but are not limited to, for example, supervised learning, unsupervised learning, semi-supervised learning, or reinforcement learning. The artificial intelligence model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but is not limited thereto. The artificial intelligence model may additionally or alternatively include a software structure other than the hardware structure.

The memory 130 may store various pieces of data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing record. The receiver may be used to receive an incoming call. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to sense a touch, or a pressure sensor adapted to measure the intensity of force incurred by the touch.

The audio module 170 may convert a sound into an electrical signal and vice versa. According to an embodiment, the audio module 170 may obtain the sound via the input module 150 or output the sound via the sound output module 155 or an external electronic device (e.g., the electronic device 102 such as a speaker or headphones) directly or wirelessly connected to the electronic device 101.

The sensor module 176 may detect an operational state (e.g., power or temperature) of the electronic device 101 or an environmental state (e.g., a state of a user) external to the electronic device 101, and generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or an electrical stimulus which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently of the processor 120 (e.g., an AP) and that support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide area network (WAN)). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), an array antenna, analog beamforming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., an external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to an embodiment, another component (e.g., a radio frequency integrated circuit (RFIC)) other than the radiating element may be additionally formed as part of the antenna module 197.

According to an embodiment, the antenna module 197 may form a mmWave antenna module. According to an embodiment, the mmWave antenna module may include a PCB, an RFIC disposed on a first surface (e.g., the bottom surface) of the PCB or adjacent to the first surface and capable of supporting a designated high-frequency band (e.g., the mmWave band), and a plurality of antennas (e.g., array antennas) disposed on a second surface (e.g., the top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of the same type as or a different type from the electronic device 101. According to an embodiment, all or some of operations to be executed at the electronic device 101 may be executed at one or more of external electronic devices (e.g., the external electronic devices 102 and 104, or the server 108). For example, if the electronic device 101 needs to perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or MEC. In an embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., a smart home, a smart city, a smart car, or healthcare) based on 5G communication technology or IoT-related technology.

The electronic device according to the embodiments disclosed herein may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic device is not limited to those described above.

It should be appreciated that embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B or C", "at least one of A, B and C", and "at least one of A, B, or C", may include any one of, or all possible combinations of the items enumerated together in a corresponding one of the phrases. As used herein, such terms as "1^{st}" and "2^{nd}," or "first" and "second" may be used to simply distinguish a corresponding component from another, and does not limit the components in other aspect (e.g., importance or order). It is to be understood that if a component (e.g., a first component) is referred to, with or without the term "operatively" or "communicatively", as "coupled with", "coupled to", "connected with", or "connected to" another component (e.g., a second component), it means that the component may be coupled with the other component directly (e.g., by wire), wirelessly, or via a third component.

As used in connection with embodiments of the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to embodiments of the disclosure may be included and provided in a computer program product. The computer program product may be traded as a product between a seller and a buyer. The computer program product may be distributed in the form of a machine-readable storage medium (e.g., compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as a memory of the manufacturer's server, a server of the application store, or a relay server.

According to embodiments, each component (e.g., a module or a program) of the above-described components may include a single entity or multiple entities, and some of the multiple entities may be separately disposed in different components. According to embodiments, one or more of the above-described components or operations may be omitted, or one or more other components or operations may be added. Alternatively or additionally, a plurality of components (e.g., modules or programs) may be integrated into a single component. In such a case, according to embodiments, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

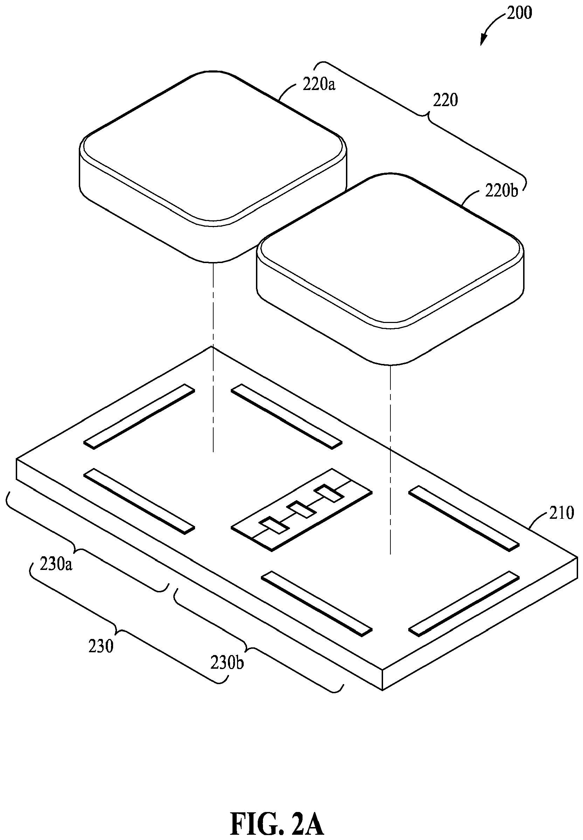

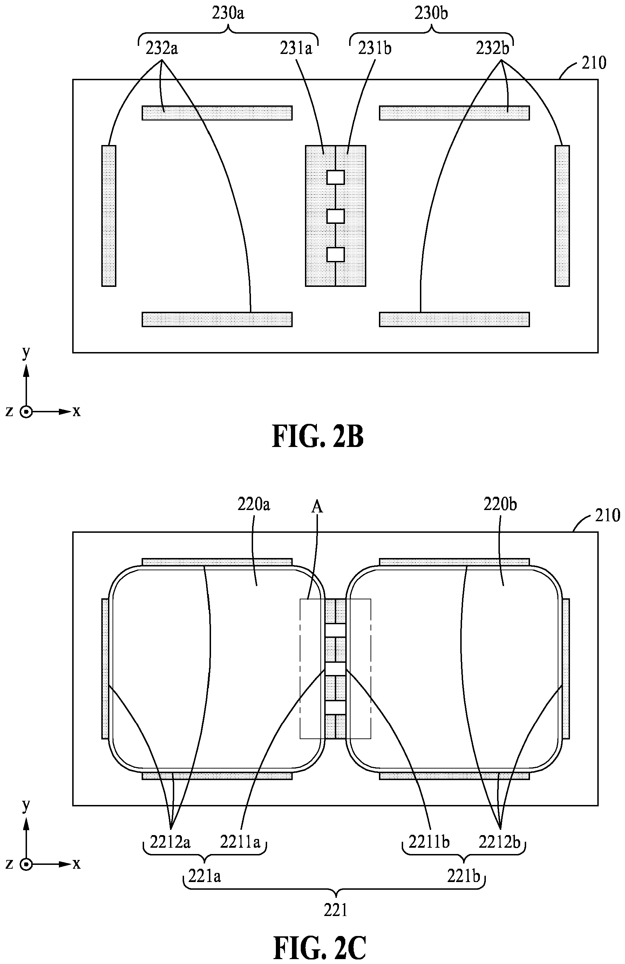

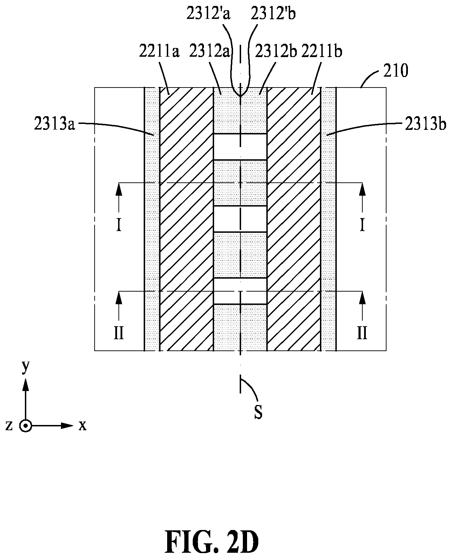

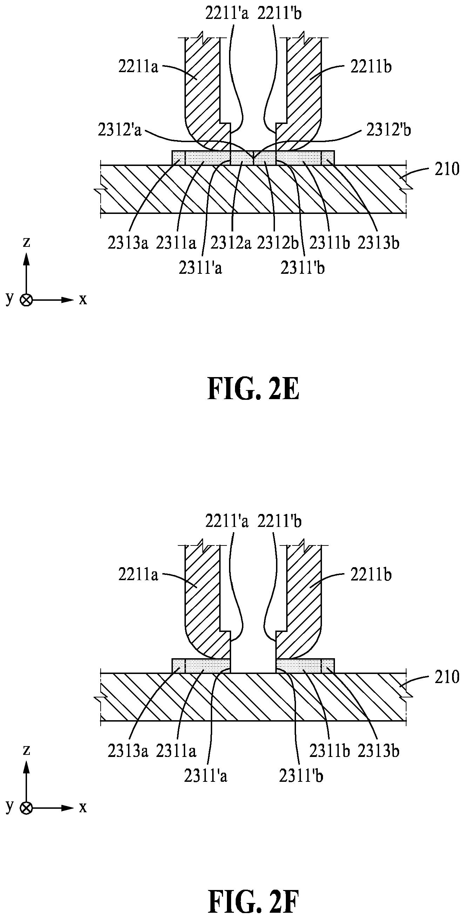

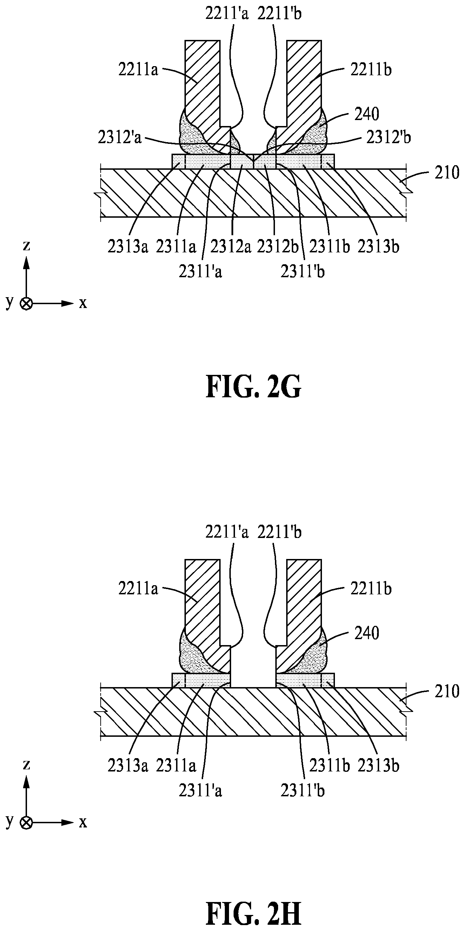

FIG. 2A is an exploded perspective view illustrating a PCB according to an embodiment. FIG. 2B is a plan view of a PCB including a bonding pad according to an embodiment. FIG. 2C is a plan view of a PCB assembly according to an embodiment. FIG. 2D is a plan view of the inside of A of FIG. 2C. FIG. 2E is a front view taken along a line I-I of FIG. 2D and illustrating a state before a bonding member is applied. FIG. 2F is a front view taken along a line II-II of FIG. 2D and illustrating a state before a bonding member is applied. FIG. 2G is a front view taken along a line I-I of FIG. 2D and illustrating a state after a bonding member is applied. FIG. 2H is a front view taken along a line II-II of FIG. 2D and illustrating a state after a bonding member is applied.

Referring to 2A to 2H, a PCB assembly 200 may be applied to various electronic devices (e.g., the electronic device 101 of FIG. 1). For example, the PCB assembly 200 may be applied to a smartphone, a tablet, a laptop computer, a digital broadcast terminal, a personal digital assistant (PDA), a portable multimedia player (PMP), or a navigation system. However, the foregoing examples are just examples, and the electronic devices, to which the PCB assembly 200 may be applied, are not limited thereto. One or more PCB assemblies 200 may be mounted on an electronic device and may implement various functions of the electronic device.

In an embodiment, the PCB assembly 200 may include a PCB 210, a shield can 220, a bonding pad 230, and a bonding member 240.

In an embodiment, a PCB 210 may be a board on which various types of electronic components (not shown) are mounted. A printed circuit (not shown) electrically connecting the various types of electronic components may be on the surface of the PCB 210. The types and sizes of the PCB 210 may vary. For example, the PCB 210 may be in a flat or flexible form.

In an embodiment, the shield can 220 may be on the PCB 210 to protect electronic components that are mounted on the PCB 210. The shield can 220 may be on the PCB 210 to cover at least one electronic component. The shield can 220 may prevent electronic components from interfering with one another due to electromagnetic waves generated by the electronic components by shielding noise and may also prevent an external electromagnetic field from interfering with internal electronic components.

In an embodiment, there may be at least one shield can 220. For example, the shield can 220 may include a first shield can 220a and a second shield can 220b. The first shield can 220a and the second shield can 220b each may be on the PCB 210 to cover an electronic component. The first shield can 220a and the second shield can 220b may be adjacent to each other.

In an embodiment, the shield can 220 may include a plurality of corners 221. The corner 221 may mean an edge of the shield can 220. The shield can 220 may be mounted on the PCB 210 with the corner 221 being mounted on the PCB 210. For example, the first shield can 220a may include a plurality of first corners 221a, and the second shield can 220b may include a plurality of second corners 221b. In addition, referring to FIGS. 2E to 2H, an edge of the corner 221a or 221b may be curved in an outward direction (e.g., a +x direction of the first corner 221a or a -x direction of the second corner 221b).

In an embodiment, as illustrated in FIG. 2C, when a pair of shield cans 220a and 220b are adjacent to each other, a corner that is adjacent to the other shield can 220b or 220a based on a shield can 220a or 220b may be referred to as an adjacent corner 2211a or 2211b, and a corner that is not adjacent to the other shield can 220b or 220a may be referred to as a non-adjacent corner 2212a or 2212b. For example, based on the first shield can 220a illustrated in FIG. 2C, a corner on the right side (e.g., the +x direction) of the plurality of first corners 221a may be a first adjacent corner 2211a, and the other corners may be a first non-adjacent corners 2212a. In addition, based on the second shield can 220b that is illustrated in FIG. 2C, a corner on the left side (e.g., the - x direction) of the plurality of second corners 221b may be a second adjacent corner 2211b, and the other corners may be a second non-adjacent corners 2212b.

In addition, although the second shield can 220b is illustrated as being adjacent to the first shield can 220a only on the right side (e.g., the +x direction) of the first shield can 220a, this is just an example, and another shield can may be adjacent to the first shield can 220a also on the left side (e.g., the -x direction), the upper side (e.g., a +y direction), or the lower side (e.g., a -y direction) of the first shield can 220a. For example, when a third shield can (not shown) is additionally arranged adjacent to the first shield can 220a on the left side (e.g., the -x direction) of the first shield can 220a that is illustrated in FIGS. 2A to 2C, the corner on the left side (e.g., the +x direction) of the plurality of first corners 221a may also be the first adjacent corner 2211a.

In an embodiment, the bonding pad 230 may be on the PCB 210 and may mediate the bonding between the PCB 210 and the shield can 220. Specifically, the bonding pad 230 may mediate the bonding between the PCB 210 and the shield can 220. The bonding pad 230 may be in a longitudinal direction corresponding to the corner 221. The width of at least some portion of the bonding pad 230 may be greater than the width of the corner 221 such that the bonding member 240 to be described below may be applied.

In an embodiment, the first bonding pad 230a may bond the first shield can 220a to the PCB 210, and the second bonding pad 230b may bond the second shield can 220b to the PCB 210. The number of first bonding pads 230a and the number of the second bonding pads 230b may respectively correspond to the number of the corners 221a of the first shield can 220a and the number of the corners 221b of the second shield can 220b. For example, as illustrated in FIG. 2B, the first bonding pad 230a and the second bonding pad 230b may each include four bonding pads. The first bonding pad 230a and the second bonding pad 230b may be respectively arranged corresponding to the first corner 221a and the second corner 221b to correspond to the shape of the first shield can 220a and the shape of the second shield can 220b.

In an embodiment, as illustrated in FIGS. 2A to 2C, when the pair of shield cans 220a and 220b are adjacent to each other, based on one of the shield cans 220a and 220b, a bonding pad corresponding to the adjacent corner 2211a or 2211b may be referred to as an adjacent bonding pad 231a or 231b, and an adjacent pad corresponding to the non-adjacent corner 2212a or 2212b may be referred to a non-adjacent bonding pad 232a or 232b. For example, based on the first shield can 220a that is illustrated in FIGS. 2A to 2C, a bonding pad on the right side (e.g., the +x direction) of the plurality of the first bonding pads 230a may be a first adjacent bonding pad 231a, and the other bonding pads may be a first non-adjacent bonding pad 232a. In addition, based on the second shield can 220b that is illustrated in FIGS. 2A to 2C, a bonding pad on the left side (e.g., the-+x direction) of the plurality of the second bonding pads 231b may be a second adjacent bonding pad 231b, and the other bonding pads may be a second non-adjacent bonding pad 232b.

In an embodiment, the first adjacent bonding pad 231a and the second adjacent bonding pad 231b may respectively correspond to a first adjacent corner 2311a and a second adjacent corner 2311b that are on the PCB 210. The first adjacent bonding pad 231a and the second adjacent bonding pad 231b may respectively mediate the bonding of the first adjacent corner 2311a to the PCB 210 and the bonding of the second adjacent corner 2311b to the PCB 210.

In addition, although the first bonding pad 230a on the right side (e.g., the +x direction) of the first shield can 220a is illustrated as being the first adjacent bonding pad 231a, this is just an example, and the first bonding pad 230 on the left side (e.g., the -x direction), the upper side (e.g., the +y direction), or the lower side (e.g., the -y direction) of the first shield can 220a may also be the first adjacent bonding pad 2211a. For example, when a corner on the left side (e.g., the -x direction), the upper side (e.g., the +y direction), or the lower side (e.g., the -y direction) of the first shield can 220a is the first adjacent corner 2211a, a bonding pad corresponding thereto may be the first adjacent bonding pad 2211a.

In an embodiment, the bonding member 240 may be applied to at least some of the bonding pad 230. For example, the bonding member 240 may include a solder. The bonding member 240 may fix the bonding between bonding pad 230 and the shield can 220 (specifically, the corner 221 of the shield can 220) by being applied to at least some of the bonding pad 230 and cured.

Hereinafter, the first adjacent bonding pad 231a and the second adjacent bonding pad 231b are specifically described with reference to FIGS. 2A to 2H. In the present disclosure, a direction in which a pair of components practically faces each other may be a facing direction, and a direction in which the pair of components is practically back against each other may be an orientation direction. For example, based on the first adjacent bonding pad 231a, a direction (e.g., the +x direction) facing the second adjacent bonding pad 231b may be the facing direction, and a direction (e.g., the -x direction) that is back against the second adjacent bonding pad 231b may be the orientation direction. For example, based on the second adjacent bonding pad 231b, a direction (e.g., the -x direction) facing the first adjacent bonding pad 231a may be the facing direction, and a direction (e.g., the +x direction) that is back against the first adjacent bonding pad 231a may be the orientation direction.

In an embodiment, the pair of the adjacent bonding pads 231a and 231b may respectively include reference structures 2311a and 2311b, facing structures 2312a and 2312b, and orientation structures 2313a and 2313b. For ease of description, the description is provided based on the first adjacent bonding pad 231a.

In an embodiment, a first reference structure 2311a may be formed and arranged in a longitudinal direction (e.g., a y direction) of the first adjacent corner 2211a corresponding to the first reference structure 2311a. The length of the longitudinal direction of the first reference structure 2311a may be less than or practically the same as the length of the longitudinal direction of the first adjacent corner 2211a. The width of a width direction (e.g., an x direction) of the first reference structure 2311a may be practically the same as the width of a width direction (e.g., the x direction) of the first adjacent corner 2211a. For example, the width of the first adjacent corner 2211a may be the length from an inner perpendicular surface (e.g., a surface in a z direction) to an edge (e.g., an edge in the +x direction) curved in the facing direction (e.g., the +x direction) on the facing side. For example, the width of the first reference structure 2311a may be about 0.2 mm to 0.3 mm. In an embodiment, the width of the first reference structure 2311a may be about 0.25 mm. However, the foregoing numerical values are examples.

In an embodiment, a first facing structure 2312a may extend in the facing direction (e.g., the +x direction) from a portion of a facing side 2311'a (e.g., a side in the +x direction) of the first reference structure 2311a. For example, the first facing structure 2312a may be in the portion of the facing side 2311'a of the first reference structure 2311a as illustrated in FIGS. 2E and 2G. The first facing structure 2312a may not be in the remaining portion of the facing side 2311'a of the first reference structure 2311a. For example, as illustrated in FIGS. 2F and 2H, a first facing structure (e.g., the first facing structure 2312a of FIGS. 2E and 2G) may not be in the remaining portion. There may be a plurality of first facing structures 2312a. For example, there may be four first facing structures 2312a as illustrated in FIG. 2D. However, this is just an example, and the number of the first facing structures 2312a may not be limited thereto. The plurality of first facing structures 2312a may be spaced apart from one another in the longitudinal direction (e.g., the y direction) of the first reference structure 2311a. For example, the plurality of first facing structures 2312a may be spaced apart from one another at a designated distance in the longitudinal direction (e.g., the y direction). For example, the plurality of first facing structures 2312a may be spaced apart from one another at an equal distance in the longitudinal direction (e.g., the y direction). On the facing side 2311'a of the first reference structure 2311a, the total length of a portion including the first facing structure 2312a may be greater than the total length of a portion not including the first facing structure 2312a. In other words, the first facing structure 2312a may be in a portion that is more than half of the facing side 2311'a of the first reference structure 2311a. In addition, the shapes illustrated in FIGS. 2A to 2D are examples, and examples are not limited thereto. In an embodiment, on the facing side 2311'a of the first reference structure 2311a, the total length of the portion including the first facing structure 2312a may be practically the same as the total length of the portion not including the first facing structure 2312a. In an embodiment, on the facing side 2311'a of the first reference structure 2311a, the total length of the portion including the first facing structure 2312a may be less than the total length of the portion not including the first facing structure 2312a.

In an embodiment, a first orientation structure 2313a may extend in the orientation direction (e.g., the -x direction) from an orientation side (e.g., a side in the -x direction) of the first reference structure 2311a. The first orientation structure 2313a may be at least some of the orientation side (e.g., the side in the -x direction) of the first reference structure 2311a. For example, the first orientation structure 2313a may be the whole orientation side (e.g., the side in the -x direction) of the first reference structure 2311a.

In an embodiment, at least some of the second adjacent bonding pad 231b may be practically symmetrical with the first adjacent bonding pad 231a. For example, the first adjacent bonding pad 231a and the second adjacent bonding pad 231b may be practically symmetrical with each other based on an imaginary longitudinal direction axis (e.g., S of FIG. 2D) at an equal distance from each other. For example, a second reference structure 2311b, a second facing structure 2312b, and a second orientation structure 2313b may respectively be practically symmetrical with the first reference structure 2311a, the first facing structure 2312a, and the first orientation structure 2313a. For example, the first reference structure 2311a and the second reference structure 2311b, the first facing structure 2312a and the second facing structure 2312b, and the first orientation structure 2131a and the second orientation structure 2313b may each be practically symmetrical with each other based on the imaginary longitudinal direction axis (e.g., S of FIG. 2D) at an equal distance from each other. To avoid excessive repetition, the above description of the first adjacent bonding pad 231a is applied to the detailed description of the second adjacent bonding pad 231b.

Hereinafter, the detailed descriptions of the first facing structure 2312a, the first orientation structure 2313a, and the first reference structure 2311a are provided based on the first adjacent bonding pad 231a. Because the second adjacent bonding pad 231b performs practically the same function as the first adjacent bonding pad 231a, to avoid excessive repetition, the description to be provided is applied to the detailed descriptions of the second facing structure 2312b, the second orientation structure 2313b, and the second reference structure 2311b.

In an embodiment, the bonding member 240 may be applied to the first facing structure 2312a, the first reference structure 2311a, and/or the first orientation structure 2313a. For example, the bonding member 240 may be applied to the first facing structure 2312a, the first reference structure 2311a, and/or the first orientation structure 2313a before the first adjacent corner 2211a is seated on the first adjacent bonding pad 231a. The bonding member 240 may also be applied to the first facing structure 2312a, the first reference structure 2311a, and/or the first orientation structure 2313a after the first adjacent corner 2211a is seated on the first adjacent bonding pad 231a. The bonding member 240 that is applied to the first facing structure 2312a, the first reference structure 2311a, and/or the first orientation structure 2313a may couple the first adjacent corner 2211a to the first adjacent bonding pad 231a through curing. For example, the bonding member 240 that is applied to the first facing structure 2312a and/or the first reference structure 2311a, by being cured, may couple the facing side (e.g., the side in the +x direction) of the first adjacent corner 2211a to the first facing structure 2312a and/or the first reference structure 2311a, and the bonding member 240 that is practically applied to the first orientation structure 2312b and/or the first reference structure 2311a, by being cured, may couple the orientation side (e.g., the side in the -x direction) of the first adjacent corner 2211a to the first orientation structure 2312b and/or the first reference structure 2311a.

In an embodiment, since the first facing structure 2312a is in a portion of the facing side 2311'a of the first reference structure 2311a, to increase the bonding force with the first corner 221a, the extending length of the first facing structure 2312a in the facing direction (e.g., the +x direction) may be greater compared to other related arts. For example, the extending length of the first facing structure 2312a in the facing direction (e.g., the +x direction) may be greater than the extending length of the first orientation structure 2313a in the orientation direction (e.g., the -x direction). For example, the extending length of the first facing structure 2312a in the facing direction (e.g., the +x direction) may be about 0.1 mm to 0.2 mm. In an embodiment, the extending length of the first facing structure 2312a in the facing direction (e.g., the +x direction) may be about 0.15 mm. For example, the extending length of the first orientation structure 2313a in the orientation direction (e.g., the -x direction) may be about 0.02 mm to 0.08 mm. In an embodiment, the extending length of the first orientation structure 2313a in the orientation direction (e.g., the -x direction) may be about 0.05 mm. The extending length of the first facing structure 2312a in the facing direction (e.g., the +x direction) may be about 2.5 times to 3.5 times greater than the extending length of the first orientation structure 2313a in the orientation direction (e.g., the -x direction). For example, when the extending length of the first orientation structure 2313a in the orientation direction (e.g., the -x direction) is about 0.05 mm, the extending length of the first facing structure 2312a in the facing direction (e.g., the +x direction) may be about 0.15 mm. However, the foregoing numerical values are examples.

In an embodiment, the first reference structure 2311a may provide an area where the first adjacent corner 2211a seats. In other words, the first adjacent corner 2211a may seat on the first adjacent bonding pad 231a but may practically seat on the first reference structure 2311a. The first shield can 220a may be arranged such that an edge 2211'a on the facing side of the first adjacent corner 2211a may be practically the same as the facing side 2311'a of the first reference structure 2311a of the first adjacent bonding pad 231a. Specifically, since the first facing structure 2312a is in a portion of the facing side 2311'a of the first reference structure 2311a, the remaining portion not including the first facing structure 2312a on the facing side 2311'a may practically function as a reference line that guides the arrangement position of the first adjacent corner 2211a. In other words, referring to the remaining portion, not including the first facing structure 2312a, of the facing side 2311'a of the first reference structure 2311a as the reference line, the edge 2211'a of the first adjacent corner 2211a may be practically the same as the facing side 2311'a of the first reference structure 2311a. According to such a structure, the shield can 220a or 220b may be prevented from leaning in the facing direction (e.g., the +x direction or the -x direction). Accordingly, even when a spacing distance between the pair of shield cans 220a and 220b is less compared to other related arts, the pair of shield cans 220a and 220b may be prevented from contacting each other. Therefore, the spacing distance between the pair of shield cans 220a and 220b may decrease while preventing the pair of shield cans 220a and 220b from contacting each other.

In an embodiment, the pair of adjacent bonding pads 231a and 231b may be arranged such that the edges of the facing structures 2312a and 2312b may contact each other. For example, the first adjacent bonding pad 231a and the second adjacent bonding pad 231b may be arranged such that an edge 2312'a of the first facing structure 2312a and an edge 2312'b of the second facing structure 2312b may contact each other. As described above, since the portions not including the respective facing structures 2312a and 2312b of the respective facing sides 2311'a and 2311'b of the respective reference structures 2311a and 2311b function as the reference line that guides the arrangement position of the respective adjacent corners 2211a and 2211b, the pair of adjacent bonding pads 231a and 231b may be adjacent until the edges 2312'a and 2312'b of the respective facing structures 2312a and 2312b may contact each other. Accordingly, the pair of adjacent bonding pads 231a and 231b may be more adjacent compared to other related arts. Therefore, since the spacing distance between the pair of shield cans 220a and 220b decreases compared to other related arts, the size of the PCB assembly 200 may decrease and the density of mounting components may increase.

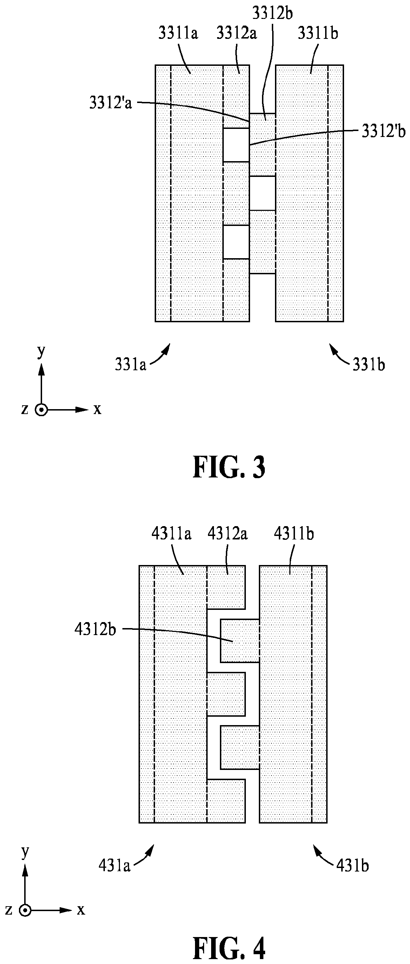

FIG. 3 is a plan view of a pair of adjacent bonding pads applied to a pair of shield cans adjacent to each other, according to an embodiment.

Referring to FIG. 3, each of facing structures 3312a and 3312b may alternate with each other in a longitudinal direction of respective adjacent bonding pads 331a and 331b. For example, a first facing structure 3312a of a first adjacent bonding pad 331a and a second facing structure 3312b of a second adjacent bonding pad 331b may alternate with each other in a longitudinal direction (e.g., a y direction) of respective reference structures 3311a and 3311b. At least one of the number of the first facing structures 3312a and the number of the second facing structures 3312b may be plural, and the first facing structure 3312a and the second facing structure 3312b may be spaced apart from each other at a designated distance in the longitudinal direction (e.g., the y direction) of the respective reference structures 3311a and 3311b. The first adjacent bonding pad 231a and the second adjacent bonding pad 231b may be arranged such that at least some of an edge 3312'a of the first facing structure 3312a and an edge 3312'b of the second facing structure 3312b may contact each other. The length of the facing structure 3312a or 3312b of one of the pair of adjacent bonding pads 331a and 331b in the longitudinal direction (e.g., the y direction) may be greater than the length of a portion not including the facing structure 3312b or 3312a in the other in the longitudinal direction (e.g., the y direction). For example, based on the first adjacent bonding pad 331a, the length of the longitudinal direction (e.g., the y direction) of the first facing structure 3312a may be greater than the length of a portion not including the second facing structure 3312b in the second adjacent bonding pad 331b in the longitudinal direction (e.g., the y direction). Even in the structure illustrated in FIG. 3, a pair of shield cans (e.g., the shield cans 220a and 220b of FIGS. 2A and 2C) may be more adjacent, compared to other related arts, and practically the same as the descriptions provided with reference to FIGS. 2A to 2H.

FIG. 4 is a plan view of a pair of adjacent bonding pads applied to a pair of shield cans adjacent to each other, according to an embodiment.

Referring to FIG. 4, each of facing structures 4312a and 4312b may alternate with each other in a longitudinal direction of respective adjacent bonding pads 431a and 431b. For example, a first facing structure 4312a of a first adjacent bonding pad 431a and a second facing structure 4312b of a second adjacent bonding pad 431b may alternate with each other in a longitudinal direction (e.g., a y direction) of respective reference structures 4311a and 4311b. At least one of the number of the first facing structures 4312a and the number of the second facing structures 4312b may be plural, and the first facing structure 4312a and the second facing structure 4312b may be spaced apart from each other at a designated distance in the longitudinal direction (e.g., the y direction) of the respective reference structures 4311a and 4311b. The facing structure 4312a or 4312b of one of the pair of adjacent bonding pads 431a and 431b may be inserted into a space not including the facing structure 4312b or 4312a in the other. For example, based on the first adjacent bonding pad 431a, the first facing structure 4312a may be inserted into a space not including the second facing structure 4312b in the second adjacent bonding pad 431b. The length of the facing structure 4312a or 4312b of one of the pair of adjacent bonding pads 431a and 431b in the longitudinal direction (e.g., the y direction) may be less than or practically the same as the length of a portion not including the facing structure 4312b or 4312a in the other in the longitudinal direction (e.g., the y direction). For example, based on the first adjacent bonding pad 431a, the length of the longitudinal direction (e.g., they direction) of the first facing structure 4312a may be less than or practically the same as the length of a portion not including the second facing structure 4312b in the second adjacent bonding pad 431b in the longitudinal direction (e.g., the y direction). Even in the structure illustrated in FIG. 4, a pair of shield cans (e.g., the shield cans 220a and 220b of FIGS. 2A and 2C) may be more adjacent, compared to other related arts, and practically the same as the descriptions provided with reference to FIGS. 2A to 2H.

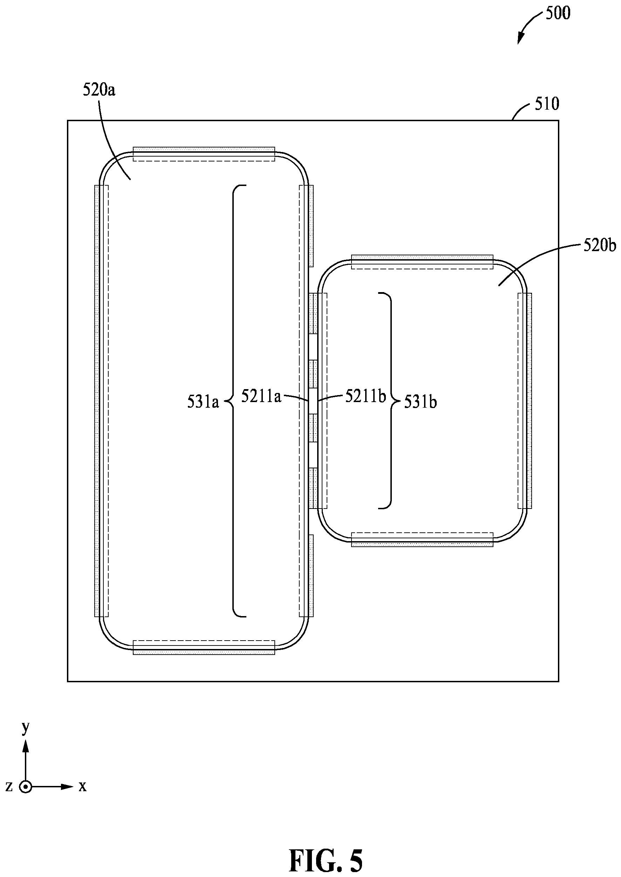

FIG. 5 is a plan view of the PCB assembly according to an embodiment.

Referring to FIG. 5, a PCB assembly 500 may include a PCB 510, a pair of shield cans 520a and 520b, a pair of adjacent bonding pads 531a and 531b, and a bonding member (not shown) (e.g., the bonding member 240 of FIGS. 2E to 2H).

In an embodiment, the pair of shield cans 520a and 520b may be formed in different sizes and/or shapes. In this case, a pair of adjacent corners 5211a and 5211b may have different lengths in a longitudinal direction (e.g., a y direction). For example, as illustrated in FIG. 5, the length of a first adjacent corner 5211a may be greater than the length of a second adjacent corner 5211b.

In an embodiment, as illustrated in FIG. 5, when the lengths of the pair of adjacent corners 5211a and 5211b are different, based on an adjacent bonding pad (e.g., the second adjacent bonding pad 531b), of which the length is relatively short, another adjacent bonding pad (e.g., the first adjacent bonding pad 531a) may be formed. In other words, in at least a portion, which is shared with the second adjacent bonding pad 531b, in the longitudinal direction (e.g., the y direction) of the first adjacent bonding pad 531b, the first adjacent bonding pad 531b may correspond to the second adjacent bonding pad 531b. For example, as illustrated in FIG. 5, in at least a portion, which is shared with the second adjacent bonding pad 531b, in the longitudinal direction (e.g., the y direction) of the first adjacent bonding pad 531a, the first adjacent bonding pad 531a may be practically symmetrical with the second adjacent bonding pad 531b. According to such a structure, even when the sizes and/or shapes of the pair of shield cans 520a and 520b are different, the pair of shield cans 520a and 520b may be more adjacent, compared to other related arts, and practically the same as the descriptions provided with reference to FIGS. 2A to 2H.

In addition, when describing the sizes and/or shapes of the pair of shield cans 520a and 520b, although the pair of adjacent bonding pads 531a and 531b are illustrated as being practically symmetrical with each other in the shared portion in FIG. 5, this is just an example, and a structure may be used as illustrated in FIG. 3 or FIG. 4, in which the respective facing structures (e.g., the facing structures 3312a and 3312b of FIG. 3 or the facing structures 4312a and 4312b of FIG. 4) of a pair of adjacent bonding pads (e.g., the adjacent bonding pads 331a and 331b of FIG. 3 or the adjacent bonding pads 431a and 431b of FIG. 4) may alternate with each other.

The drawings accompanying the present disclosure are just examples, and the number, shape, length, and/or ratio of each specification are not limited thereto.

According to an embodiment, a PCB assembly 200 includes a PCB 210; a pair of shield cans 220a or 220b adjacent to each other on the PCB 210 such that a pair of adjacent corners 2211a or 2211b adjacent to each other is parallel to each other; and a pair of adjacent bonding pads 231a or 231b corresponding to the pair of adjacent corners 2211a or 2211b on the PCB 210 and configured to mediate bonding between the pair of adjacent corners 2211a or 2211b and the PCB 210, in which each of the pair of adjacent bonding pads 231a or 231b includes a reference structure 2311a or 2311b and a facing structure 2312a or 2312b, in which the reference structure 2311a or 2311b is formed in a longitudinal direction of the pair of adjacent corners 2211a or 2211b and the facing structure extends in a facing direction in a portion on a facing side 2311'a or 2311'b of the reference structure 2311a or 2311b, and the pair of adjacent bonding pads 231a or 231b is arranged such that edges of the facing structure 2312a or 2312b contact each other, or the facing structure 3312a or 3312b of one of the pair of adjacent bonding pads 331a or 331b and the facing structure 3312a or 3312b of the other of the pair of adjacent bonding pads 331a or 331b alternate with each other in the longitudinal direction of the reference structure 3311a or 3311b.

In an embodiment, the shield can 220a or 220b may be arranged such that an edge 2211'a or 2211'b of the facing side of the adjacent corner 2211a or 2211b may coincide with the facing side 2311'a or 2311'b of the reference structure 2311a or 2311b.

In an embodiment, based on at least one of the pair of adjacent bonding pads 231a and 231b, there may be the plurality of facing structures 2312a or 2312b, and the plurality of facing structures 2312a or 2312b may be spaced apart from one another at a designated distance in the longitudinal direction of the reference structure 2311a or 2311b.

In an embodiment, each of the pair of adjacent bonding pads 231a and 231b may further include an orientation structure 2313a or 2313b extending in an orientation direction on an orientation side of the reference structure 2311a or 2311b.

In an embodiment, the width of the reference structure 2311a or 2311b may be the same as the width of the adjacent corner 2211a or 2211b corresponding thereto.

In an embodiment, the length of the facing structure 2312a or 2312b extending in the facing direction may be greater than the length of the orientation structure 2313a or 2313b extending in the orientation direction.

In an embodiment, based on at least one of the pair of adjacent bonding pads 231a and 231b, the total length of the facing structure 2312a or 2312b on the facing side 2311'a or 231 1'b of the reference structure 2311a or 2311b may be greater than the total length of a portion not including the facing structure 2312a or 2312b.

In an embodiment, the pair of adjacent bonding pads 231a and 231b may be arranged such that the respective edges 2312'a and 2312'b of the facing structures 2312a and 2312b may contact each other, and at least some of the pair of adjacent bonding pads 231a and 231b may be symmetrical with each other.

In an embodiment, the plurality of facing structures 2312a or 2312b may be spaced apart from one another at an equal distance in the longitudinal direction of the reference structure 2311a or 2311b.

In an embodiment, the bonding member 240 may be applied to the facing structures 2312a or 2312b to bond the adjacent corner 2211a or 2211b and the adjacent bonding pad 231a or 231b.

In an embodiment, the facing structure 3312a or 3312b of one of the pair of adjacent bonding pads 331a and 331b and the facing structure 3312b or 3312a of the other may alternate with each other in the longitudinal direction of the reference structure 3311a and 3311b, and the pair of adjacent bonding pads 331a and 331b may be arranged such that at least some of the respective edges 3312'a and 3312'b of the facing structures 3312a and 3312b contact each other.

In an embodiment, the length of the facing structure 3312a or 3312b of one of the pair of adjacent bonding pads 331a and 331b in the longitudinal direction may be greater than the length of a portion not including the facing structure 3312b or 3312a in the other of the pair of adjacent bonding pads 331a and 331b.

In an embodiment, the facing structure 4312a or 4312b of one of the pair of adjacent bonding pads 431a and 431b and the facing structure 4312b or 4312a of the other may alternate with each other in the longitudinal direction of the reference structure 4311a and 4311b, and the facing structure 4312a or 4312b of one of the pair of adjacent bonding pads 431a and 431b may be inserted into a space not including the facing structure 431b or 431a in the other.

In an embodiment, the length of the facing structure 4312a or 4312b of one of the pair of adjacent bonding pads 431a and 431b in the longitudinal direction may be less than the length of a portion not including the facing structure 4312b or 4312a in the other of the pair of adjacent bonding pads 431a and 431b.

In an embodiment, the length of the facing structure 4312a or 4312b of one of the pair of adjacent bonding pads 431a and 431b in the longitudinal direction may be the same as the length of the portion not including the facing structure 4312b or 4312a in the other of the pair of adjacent bonding pads 431a and 431b.

## Claims

1. A printed circuit board comprising:
a pair of shield cans adjacent to each other on the printed circuit board such that a pair of adjacent corners adjacent to each other is parallel to each other; and
a pair of adjacent bonding pads corresponding to the pair of adjacent corners on the printed circuit board and configured to mediate bonding between the pair of adjacent corners and the printed circuit board, wherein
each of the pair of adjacent bonding pads comprises a reference structure and a facing structure, in which the reference structure is formed in a longitudinal direction of the pair of adjacent corners and the facing structure extends in a facing direction in a portion on a facing side of the reference structure, and
the pair of adjacent bonding pads is arranged such that edges of the facing structure contact each other, or the facing structure of one of the pair of adjacent bonding pads and the facing structure of the other of the pair of adjacent bonding pads alternate with each other in the longitudinal direction of the reference structure.

2. The printed circuit board of claim 1, wherein
one of the pair of shield cans is arranged such that an edge on the facing side of one of the pair of adjacent corners coincides with the facing side of the reference structure.

3. The printed circuit board of claim 1, wherein,
based on at least one of the pair of adjacent bonding pads, a plurality of facing structures is formed and spaced apart from one another in the longitudinal direction of the reference structure.

4. The printed circuit board of claim 1, wherein
each of the pair of adjacent bonding pads further comprises an orientation structure extending in an orientation direction on an orientation side of the reference structure.

5. The printed circuit board of claim 4, wherein
a width of the reference structure is the same as a width of one of the pair of adjacent corners.

6. The printed circuit board of claim 5, wherein
a length of the facing structure extending in the facing direction is greater than a length of the orientation structure extending in the orientation direction.

7. The printed circuit board of claim 1, wherein,
based on at least one of the pair of adjacent bonding pads, a total length of a portion, in which the facing structure is on the facing side of the reference structure, is greater than a total length of a portion not comprising the facing structure.

8. The printed circuit board of claim 1, wherein
the pair of adjacent bonding pads are arranged such that the edges of the facing structure contact each other, and
at least some of the pair of adjacent bonding pads are symmetrical with each other.

9. The printed circuit board of claim 3, wherein
the plurality of facing structures is spaced apart from each other at an equal distance in the longitudinal direction of the reference structure.

10. The printed circuit board of claim 1, wherein
a bonding member is applied to the facing structure to bond one of the pair of adjacent corners and one of the pair of adjacent bonding pads.

11. The printed circuit board of claim 1, wherein
the pair of adjacent bonding pads is arranged such that at least some of the edges of the facing structure contact each other, and the facing structure of one of the pair of adjacent bonding pads and the facing structure of the other of the pair of adjacent bonding pads alternate with each other in the longitudinal direction of the reference structure.

12. The printed circuit board of claim 11, wherein
a length of the facing structure of one of the pair of adjacent bonding pads in a longitudinal direction of the facing structure is greater than a length of a portion not comprising the facing structure in the other of the pair of adjacent bonding pads.

13. The printed circuit board of claim 1, wherein
the facing structure of one of the pair of adjacent bonding pads and the facing structure of the other of the pair of adjacent bonding pads alternate with each other in the longitudinal direction of the reference structure, and
the facing structure of one of the pair of adjacent bonding pads is inserted into a space not comprising the facing structure in the other of the pair of adjacent bonding pads.

14. The printed circuit board of claim 13, wherein
a length of the facing structure of one of the pair of adjacent bonding pads in a longitudinal direction of the facing structure is less than a length of a portion not comprising the facing structure in the other of the pair of adjacent bonding pads.

15. The printed circuit board of claim 13, wherein
a length of the facing structure of one of the pair of adjacent bonding pads in a longitudinal direction of the facing structure is the same as a length of a portion not comprising the facing structure in the other of the pair of adjacent bonding pads.
